# EUROPÄISCHE PATENTSCHRIFT

(11) **EP 2 312 919 B1**
(45) Veröffentlichungstag und Bekanntmachung des Hinweises auf die Patenterteilung: **13.03.2013**
(21) Anmeldenummer: 10175101.4
(22) Anmeldetag: 02.09.2010
(51) Int. Cl.: H05K 1/14, G06K 7/10

(54) **Optoelektronischer Sensor**
Optoelectronic sensor
Capteur optoélectronique

(30) Priorität: 08.10.2009 EP 09172582
(43) Veröffentlichungstag der Anmeldung: 20.04.2011
(73) Patentinhaber: SICK AG, 79183 Waldkirch (DE)
(72) Erfinder: Nübling, Ralf Ulrich, 79211 Denzlingen (DE); Anselment, Christoph, 79183 Waldkirch (DE); Pastor, Sebastian, 79104 Freiburg (DE)
(74) Vertreter: Hehl, Ulrich

(56) Entgegenhaltungen:
- EP-A1- 1 202 405
- EP-A1- 1 709 899
- WO-A1-00/51063
- US-A- 4 143 809
- US-A- 5 164 573
- US-A- 5 187 353

## Beschreibung

Die Erfindung betrifft einen optoelektronischen Sensor nach dem Oberbegriff von Anspruch 1 sowie ein Herstellungsverfahren für einen derartigen Sensor nach dem Oberbegriff von Anspruch 9.

Es ist eine Vielzahl optoelektronischer Sensoren bekannt, die nach einem Tasterprinzip arbeiten. Dabei wird ein Lichtstrahl ausgesandt und nach Reflexion an einem Objekt auf nahezu demselben Lichtweg wieder empfangen. Einfache Lichttaster erkennen so, ob sich ein Objekt im Erfassungsbereich des Sensors befindet oder nicht.

Abstandsmessende Systeme bestimmen zusätzlich die Lichtlaufzeit bis zu dem Objekt und daraus mit Hilfe der konstanten Lichtgeschwindigkeit die Entfernung des Objekts. Dazu werden entweder in pulsbasierten Sensoren einzelne Lichtpulse ausgesandt und die Zeit bis zum Empfang gemessen, oder es wird ein moduliertes Signal ausgesandt und die Lichtlaufzeit aus der Phasenverschiebung zu dem empfangenen Signal ermittelt.

In einem Laserscanner sorgt ein zusätzlicher Drehspiegel oder ein Polygonspiegelrad für eine periodische Ablenkung des Lichtstrahls und es werden zwei- und auch dreidimensionale Bereiche abgetastet. Entfernungsmessende Laserscanner bestimmen zusätzlich die jeweiligen Lichtlaufzeiten und messen so ein Abstandsprofil.

Die Sende- und Empfangseinheiten derartiger Sensoren benötigen viel Bauraum. Die Elemente müssen bei der Herstellung aufwändig justiert werden. Meist besteht eine Gehäuseanbindung und damit eine große Toleranzkette, die den Justageaufwand weiter erhöht.

In der WO 00/51063 A1 ist ein Barcodescannermodul mit einem optischen Linsensystem beschrieben, in dessen zentraler Bohrung eine Lichtquelle montiert ist. In einer Ausführungsform befinden sich Lichtquelle, ein Photodetektor und die Elektronik auf einer gemeinsamen Leiterplatte.

Leiterplatten mit starren Teilbereichen und flexiblen Zwischenbereichen sind aus dem Stand der Technik bekannt. Solche Leiterplatten werden einfach oder mehrfach gefaltet und nutzen so den verfügbaren Raum effektiv aus. Bei Starrflexplatinen bestehen die flexiblen Zwischenbereiche aus einem anderen Material als die eigentliche Leiterplatte, beispielsweise aus einem Kunststoff wie Polyimid, das in einem eigenen Fertigungsschritt angebracht wird. Alternativ ist auch bekannt, die Zwischenbereiche durch Abspanen abzutragen, bis nur noch eine dünne, flexible Schicht übrig ist.

In der DE 10 2007 017 917 B4 wird eine Funktionseinheit für einen optoelektronischen Sensor offenbart, dessen Leiterplatte einen starren Hauptbereich mit Sender und Empfänger und einen durch einen flexiblen Verbindungsbereich verbundenen Nebenbereich mit äußeren Anschlüssen aufweist. Dieser Sensor arbeitet nach dem Doppelaugenprinzip, Sender und Empfänger liegen nebeneinander auf dem Hauptbereich, und es wird eine Doppellinse benötigt. Dieser Aufbau ist für viele Anwendungen nicht kompakt und robust genug, beispielsweise weil Streulicht des Lichtsenders oder sonstiges Fremdlicht den Empfänger treffen kann.

Die EP 1 202 405 A1 offenbart ein Sendemodul für einen optischen Codeleser. In das Gehäuse des Senders ist eine Blende integriert, um einen zentralen Anteil des ausgesandten Laserstrahls zu selektieren. Weiterhin ist in dem Gehäuse eine Monitordiode vorgesehen.

In der EP 1 709 899 A1 wird ein Endoskop mit mehreren starren Leiterplatten beschrieben, die durch flexible Leiterplatten miteinander verbunden sind. Die starren Leiterplatten werden in dem Endoskop aufeinander gestapelt, indem die flexiblen Leiterplatten abwechselnd in entgegengesetzten Richtungen gefaltet werden. Auf der obersten Leiterplatte sind Beleuchtungseinrichtungen, auf der zweitobersten ist ein Bildsensor angeordnet.

Aus der WO 00/51063 A1 ist ein Barcodescannermodul mit einem optischen Linsensystem bekannt, in dessen zentraler Bohrung eine Lichtquelle montiert ist. In einer Ausführungsform befinden sich Lichtquelle, ein Photodetektor und die Elektronik auf einer gemeinsamen Leiterplatte.

Aus der US 4,143,809 ist ein Barcodeleser bekannt, bei dem Lichtsender und Lichtempfänger nebeneinander auf einer Leiterplatte angeordnet sind. Die dementsprechend nebeneinander angeordneten Sende- und Empfangslinsen sind als Elemente einer gemeinsamen Trägerstruktur ausgebildet, die sich auf der Leiterplatte abstützt.

Die US 5,187,353 A, die als nachstliegender Stand der Technik angesehen wird, beschreibt einen Barcodescanner, bei dem eine Monitordiode für den Lasersender zugleich als Empfänger des eigentlichen Lichtsignals fungiert, das von dem Barcode remittiert wird. Dazu wird die Monitordiode rückwärtig und gegenüber der optischen Achse des Lasersenders versetzt angeordnet. Eine Empfangsoptik aus einer Streulinse, einer Blende und einer Sammellinse wird mit Hilfe eines Gehäuses vor dem Lasersender gehaltert.

Es ist daher Aufgabe der Erfindung, einen optoelektronischen Sensor mit kompakter Bauform anzugeben.

Diese Aufgabe wird durch einen Sensor gemäß Anspruch 1 sowie ein entsprechendes Herstellungsverfahren gemäß Anspruch 9 gelöst. Dabei geht die Lösung von dem Grundgedanken aus, möglichst viele Justageschritte durch die Konstruktion zu ersetzen oder zu vereinfachen. Dazu wird die Empfangsoptik mit Abstandselementen versehen, welche bei der Montage automatisch den gewünschten Abstand zwischen einem Leiterplattenabschnitt des Lichtempfängers, auf dem die Abstandselemente befestigt werden, und der Empfangsoptik erzwingt. Dadurch entsteht ein einfach herzustellendes Modul von Sende- und Empfangseinheit, welches unabhängig von einem Gehäuse funktionsfähig ist und mit verschiedenen Gehäusen, aber auch weiteren optischen Elementen, wie etwa einem Drehspiegel, kombiniert werden kann.

Die Erfindung hat den Vorteil, dass ein kostengünstiger, einfacher und kompakter Modulaufbau mit deutlich reduziertem Justageaufwand ermöglicht wird. Eine Justage der Empfangsoptik, insbesondere längs der optischen Achse, ist nicht mehr erforderlich. Das Modul mit Sender und Empfänger ist vielseitig für eine ganze Familie verschiedener Sensortypen einsetzbar. Da die Elemente sich gegenseitig haltern und in ihrer relativen Lage fixieren, ist das Modul frei von Fremdeinflüssen, beispielsweise Gehäuseverzug bei der Montage des Sensors an seinem Einsatzort.

Die Empfangsoptik weist bevorzugt eine Empfangslinse auf, welche die Abstandselemente aufweist. In einer besonders bevorzugten Ausführungsform sind Abstandselemente und Empfangslinse einstückig ausgebildet, insbesondere in Form angespritzter Befestigungsbeine. Die Abstandselemente fixieren die Empfangsoptik gegenüber dem Lichtempfänger. So wird das Sensormodul auf einfache Weise besonders kompakt und weitgehend justagefrei stabilisiert. Nach dem Prinzip des Dreibeins genügen drei Abstandselemente beziehungsweise Befestigungsbeine, um die dreidimensionale Lage zu fixieren, obwohl auch eine von dieser optimalen Wahl abweichende Anzahl denkbar ist.

Die Abstandselemente durchdringen Öffnungen in dem ersten Leiterplattenabschnitt und fixieren somit die Lage des ersten Leiterplattenabschnitts gegenüber der Lage des zweiten Leiterplattenabschnitts. Zumindest in Querrichtung ist aufgrund dieser Konstruktion allenfalls noch eine geringfügige Scherung möglich. Sobald der Lichtsender justiert ist, kann auch in Längsrichtung, also parallel zu dessen optischer Achse, eine Fixierung erfolgen, beispielsweise durch Verkleben der Abstandselemente in den Öffnungen.

Der Lichtsender ist bevorzugt in einem Empfangsbereich des Lichtempfängers angeordnet. Der Empfangsbereich des Lichtempfängers wird in vielen Anwendungen als Empfangskegel bezeichnet. Die räumliche Form des Empfangsbereichs hängt dabei maßgeblich von den dem Lichtempfänger zugeordneten Elementen ab, beispielsweise einer Empfangsoptik, Blenden oder dergleichen. Aufgrund der erfindungsgemäßen Anordnung liegt der Lichtsender vor dem Lichtempfänger, verdeckt dabei aber nur einen vernachlässigbaren Anteil in dem Empfangsbereich. Dies lässt sich vorteilhafterweise erreichen, indem der Lichtsender insbesondere auf einem Steg in einer Aussparung des ersten Leiterplattenabschnitts angeordnet ist. Noch bevorzugter ist der Steg Teil des ersten Leiterplattenabschnitts und somit einstückig mit der Leiterplatte ausgebildet. Dazu wird beispielsweise eine im Wesentlichen kreisförmige Aussparung in die Leiterplatte geschnitten oder gefräst, wobei ein Steg erhalten bleibt, der gleichzeitig noch stabil genug ist, um den Lichtsender stabil zu fixieren, und dabei so schmal wie möglich ist, um möglichst viel Empfangslicht durch die Aussparung passieren zu lassen.

Vorteilhafterweise ist eine Sendeoptik in die Empfangsoptik integriert, wobei insbesondere die Sendeoptik das Zentrum der Empfangsoptik bildet. Damit sind Sende- und Empfangsoptik ohne eigenen Justageschritt richtig zueinander ausgerichtet. Beispielsweise wird in das Zentrum einer größeren Sammellinse als Empfangsoptik eine weitere Sammellinse als Sendeoptik eingespritzt, und so entsteht ein gemeinsames Linsensystem als Sende- und Empfangsoptik.

Bevorzugt ist ein Tubus um die Sendeoptik vorgesehen, um die Sendeoptik von der Empfangsoptik abzuschirmen. Damit ist der Sendekanal gegenüber dem Empfangskanal vollständig abgeschirmt, so dass optisches Übersprechen vermieden ist. Der Tubus kann verlängert werden und in ein gerades oder gekrümmtes Senderohr übergehen, um Streulicht außerhalb eines engen Winkelbereichs auszuschließen. Dies ist besonders nützlich, falls der Sensor ein Scanner ist, weil dann nur Licht des jeweils abgetasteten Winkels erfasst wird. Der Tubus kann auch dazu dienen, die Sendeoptik gegenüber der Empfangsoptik zu fixieren.

Der Tubus hat besonders bevorzugt Lötelemente zur Montage und Justierung in dem ersten Leiterplattenabschnitt. Die Fixierung des Tubus' in einer gewünschten Lage auf in dem ersten Leiterplattenabschnitt schafft zusätzliche Stabilität und die Möglichkeit, den Lichtsender mittels geeigneter Befestigung des Tubus' zu justieren. Dafür eignet sich außer einer Löt- auch eine Klebeverbindung oder eine Kombination aus beidem. Weiterhin sind mechanische Verformung oder thermisches Fügen denkbar.

In einer bevorzugten Ausführungsform sind der erste Leiterplattenabschnitt und der zweite Leiterplattenabschnitt Teil einer gemeinsamen Leiterplatte mit mindestens einem flexiblen Verbindungsbereich, wobei insbesondere ein dritter Leiterplattenabschnitt zwischen dem ersten Leiterplattenabschnitt und dem zweiten Leiterplattenabschnitt vorgesehen ist und der Abstand zwischen Lichtsender und Lichtempfänger durch die Dimensionen des dritten Leiterplattenabschnitts bestimmt ist. Damit wird eine noch einfachere, stabilere und kompaktere Bauform ermöglicht.

Insbesondere sind dabei erster Leiterplattenabschnitt zu drittem Leiterplattenabschnitt sowie dritter Leiterplattenabschnitt zu zweitem Leiterplattenabschnitt um jeweils 90° gefaltet. Abgesehen von den gering wählbaren Dimensionen der Verbindungsbereiche ist dann der Abstand zwischen Lichtsender und Lichtempfänger durch Länge des dritten Leiterplattenabschnitts und damit erneut konstruktiv vorgegeben. Die gemeinsame Leiterplatte wird mittels der Verbindungsbereiche bevorzugt so gefaltet, dass der Lichtsender in dem Empfangsbereich des Lichtempfängers angeordnet ist.

Alternativ zu einer gemeinsamen Leiterplatte sind zwei getrennte Leiterplatten vorgesehen, welche den ersten und zweiten Leiterplattenabschnitt bilden. Die notwendigen elektronischen Verbindungen zwischen den Leiterplattenabschnitten werden dann auf eine beliebige bekannte Weise realisiert, beispielsweise durch ein flexibles Flachbandkabel. Die Leiterplattenabschnitte selbst sind sowohl im Falle einer gemeinsamen Leiterplatte als auch mehrerer Leiterplatten in sich bevorzugt starr.

Der Sensor ist bevorzugt als Scanner mit einem Drehspiegel oder einem Polygonspiegelrad ausgebildet, mit dem der Lichtstrahl periodisch über einen Scanbereich ablenkbar ist. Insbesondere ist der Sensor ein Barcodeleser. Das stabile, kompakte Modul führt hier zu besonders kleinen Bauformen von Scannern.

Der Sensor ist bevorzugt als entfernungsmessender Sensor nach einem Lichtlaufzeitprinzip ausgebildet, indem eine Auswertungseinheit des Sensors die Lichtlaufzeit zwischen Aussenden und Empfang eines Lichtsignals oder den Phasenunterschied zwischen gesendetem und empfangenem moduliertem Licht bestimmt. So werden zusätzliche Informationen aus dem Erfassungsbereich des Sensors gewonnen. Kombiniert man einen entfernungsmessenden Sensor mit einem Scanner, so entsteht ein entfernungsmessender Laserscanner, der ein Abstandsprofil aufnimmt. Bei Bedarf kann der Scanstrahl auch in einer zweiten Achse quer zu derjenigen, in welcher der Drehspiegel oder das Polygonspiegelrad ablenkt, eine periodische Scanbewegung ausführen, um sogar dreidimensionale Entfernungsbilder zu gewinnen.

Das erfindungsgemäße Herstellungsverfahren ermöglicht, auf einfache Weise ein stabiles, kompaktes und weitgehend justagefreies Sende-/Empfangsmodul zu erzeugen. Dieses Modul bildet die Grundlage für eine ganze Sensorfamilie, wenn es in ein geeignetes Gehäuse eingesetzt wird, in dem weitere optische und elektronische Komponenten enthalten sind.

Vorteilhafterweise werden einer Empfangslinse der Empfangsoptik als Abstandselemente Befestigungsbeine angespritzt, und die Empfangsoptik mit den Befestigungsbeinen wird durch Öffnungen des ersten Leiterplattenabschnitts hindurch gesteckt, um die Lage des ersten Leiterplattenabschnitts gegenüber der Lage des zweiten Leiterplattenabschnitts zu fixieren. Dabei bilden die beiden Leiterplattenabschnitte vorzugsweise zueinander parallele Ebenen. Denn meist soll der Lichtsender dieselbe optische Achse haben wie der Lichtempfänger, und das ist in dieser Anordnung besonders einfach erreichbar. Es ist aber auch eine absichtliche Dezentrierung denkbar.

Das Anspritzen ist eine besonders einfache Möglichkeit, die Empfangsoptik mit Befestigungsbeinen zu versehen, wobei aber auch andere Verfahren denkbar sind, beispielsweise Einsetzen der Empfangslinse in eine Aufnahme eines Kunststoffteils mit entsprechenden Befestigungsbeinen. So wird eine vorhandene Empfangsoptik modifiziert, um das Sende-/Empfangsmodul zu justieren und zu fixieren.

Der Lichtsender wird bevorzugt justiert, indem bei aktiviertem Lichtsender durch Änderung der Lage des Lichtsenders eine maximale oder eine vorgegebene Intensität des Empfangssignals des Lichtempfängers eingestellt und anschließend die eingestellte Position fixiert wird, insbesondere durch Befestigen der Befestigungsbeine in den Öffnungen. Damit ist die Justierung bereits abgeschlossen, denn eine Justage des Lichtempfängers gegenüber der Empfangsoptik ist wegen der Festlegung durch die Befestigungsbeine nicht erforderlich. Die Justierung des Lichtsenders erfolgt im Allgemeinen in allen drei Achsen. Je nach Geräteausprägung kann auch auf eine Justage in Querrichtung verzichtet werden, so dass nur der Abstand parallel zur optischen Achse eingestellt wird, also die Fokuslage. Bei entsprechend geringen Genauigkeitsanforderungen kann es sogar genügen, gar nicht zu justieren und die Lage des Lichtsenders in allen Achsen über Teiletoleranzen abzubilden.

Um Justierungen des Lichtsenders zu ermöglichen, können beispielsweise die Befestigungsbeine zunächst etwas Spiel in den Öffnungen des ersten Leiterplattenabschnitts haben, so dass in gewissen Grenzen Scherbewegungen der Leiterplatte und damit Veränderung der relativen Lage von Lichtsender zu Lichtempfänger möglich bleiben, bis die Befestigungsbeine in den Öffnungen fixiert werden. Ähnlich kann auch die Montage der Befestigungsbeine in dem zweiten Leiterplattenabschnitt zunächst noch nicht ganz fix vorgegeben sein. Eine Möglichkeit ist, metallische Enden der Befestigungsbeine auf etwas größeren Pads zu verlöten, wo sie anfangs noch etwas Bewegungsfreiheit besitzen. Alternativ können aber auch enge Öffnungen zum Einstecken der Befestigungsbeine oder kleine Pads zur genauen Fixierung vorgesehen sein. Das hängt davon ab, wie groß die Fertigungstoleranzen einerseits und die Anforderungen des Sensors andererseits sind und ob damit eine vorgegebene Justierung ausreicht oder individuell nachjustiert werden muss. Alternativ zu Lötprozessen sind andere Fixierungen, beispielsweise ein Klebeprozess, Verstemmen oder Warmverformung denkbar.

Bevorzugt wird ein Tubus zwischen einer dem Lichtsender zugeordneten Sendeoptik und der Empfangsoptik angeordnet und auf dem ersten Leiterplattenabschnitt montiert. Dieser Tubus kann zu einem Senderohr verlängert sein. Durch den Tubus wird optisches Übersprechen des Lichtsenders auf den Lichtempfänger verhindert, zumindest zum Teil aber auch störendes Streulicht von außen abgeschirmt. Zugleich dient der Tubus dazu, die Justierung zwischen Lichtsender und Sendeoptik zu fixieren.

Um den Lichtsender wird bevorzugt eine Aussparung für das Empfangslicht angebracht, so dass der Lichtsender nur noch von einen schmalen Steg des ersten Leiterplattenabschnitts gehalten wird. Damit wird in einem einfachen Fertigungsschritt eine stabile, justagefreie Halterung für den Lichtsender geschaffen, welche nur einen unmerklichen Anteil des Empfangslichts unterdrückt.

Der erste Leiterplattenabschnitt und der zweite Leiterplattenabschnitt sind bevorzugt Teil einer gemeinsamen Leiterplatte mit mindestens einem flexiblen Verbindungsbereich, wobei die gemeinsame Leiterplatte mittels der Verbindungsbereiche so gefaltet wird, dass der Lichtsender in dem Empfangsbereich des Lichtempfängers angeordnet ist. In der so erreichten Lage wird die gemeinsame Leiterplatte dann durch Montage der Abstandselemente fixiert.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Schnittdarstellung einer ersten Ausführungsform eines erfindungsge- mäßen Sensors mit Lichtsender und Lichtempfänger sowie zugeordneten Optiken;
- Fig. 2: eine Draufsicht auf einen ersten Leiterplattenabschnitt des Sensors gemäß Figur 1;
- Fig. 3: eine Draufsicht auf einen zweiten Leiterplattenabschnitt des Sensors ge- mäß Fig. 1;
- Fig. 4: eine Detailansicht aus Figur 2 mit einem Steg und dem darauf montierten Lichtempfänger;
- Fig. 5: eine Schnittdarstellung einer weiteren Ausführungsform eines erfindungs- gemäßen Sensors mit Lichtsender und Lichtempfänger sowie zugeordne- ten Optiken; und
- Fig. 6: eine Draufsicht auf eine gemeinsame Leiterplatte des Sensors gemäß Fi- gur 5.

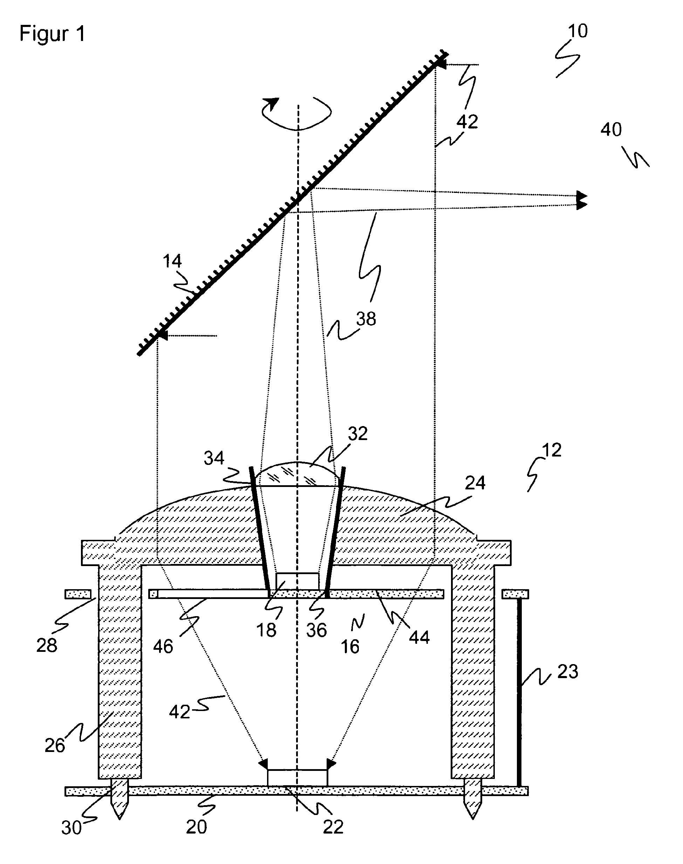

Figur 1 zeigt eine Schnittdarstellung des Inneren eines Sensors 10. Dabei sind ein Sende-/Empfangsmodul 12 und ein Drehspiegel 14 dargestellt. Weitere Elemente, wie optionale zusätzliche Leiterkarten zur Steuerung und Auswertung, Anschlüsse, Gehäuse und dergleichen sind der besseren Übersichtlichkeit halber weggelassen. Obwohl mit dem Drehspiegel 14 ein Scanner als Sensor 10 gezeigt ist, kann das Sende-/ Empfangsmodul 12 bei einer großen Vielfalt anderer Sensoren eingesetzt werden, von denen einleitend einige beispielhaft genannt sind.

Das Sende-/Empfangsmodul 12 weist einen ersten Leiterplattenabschnitt 16 mit einem Lichtsender 18 und einen zweiten Leiterplattenabschnitt 20 mit einem Lichtempfänger 22 auf. Als Lichtquelle des Lichtsenders 18 eignen sich vor allem Halbleiterlichtquellen, also LEDs, VCSELs (Vertical-Cavity Surface-Emitting Laser) oder andere Laser. Der Lichtempfänger 22 kann eine einfache Photodiode, grundsätzlich aber auch ein CCD-oder CMOS-Chip sein. Die beiden Leiterplattenabschnitte 16, 20 sind über ein in aller Regel mehradriges Kabel 23 verbunden, beispielsweise ein flexibles Flachbandkabel.

Einer beispielhaft als einfache Sammellinse dargestellten Empfangsoptik 24 sind Befestigungsbeine 26 angespritzt. Die Befestigungsbeine 26 sind durch Öffnungen 28 in dem ersten Leiterplattenabschnitt 16 hindurch gesteckt und in dem zweiten Leiterplattenabschnitt 20 in weiteren Öffnungen 30 montiert. Alternativ können die Befestigungsbeine 26 auch mit dem zweiten Leiterplattenabschnitt 20 verlötet oder verklebt werden. Die Empfangsoptik 24 stabilisiert auf diese Weise die räumliche Anordnung der Leiterplattenabschnitte 16, 20 und damit das Sende-/Empfangsmodul 12. Durch die Länge der Befestigungsbeine 26 wird auch die Bildschnittweite eingestellt, also der Abstand zwischen Empfangsoptik 24 und Lichtempfänger 22.

Eine wiederum beispielhaft als einfache Sammellinse dargestellte Sendeoptik 32 ist in die Empfangsoptik 24 integriert. Sie kann bei der Herstellung direkt mit in die Empfangsoptik 24 eingespritzt werden. Von der Empfangsoptik 24 wird sie optisch durch einen Sendetubus oder Abschirmtubus 34 getrennt, der in dem ersten Leiterplattenabschnitt 16 beispielsweise über Tubus-Beinchen 36 in Löchern 48 des ersten Leiterplattenabschnitts 16 verklebt oder verlötet wird. Dazu wird der Abschirmtubus 34 vorteilhaft aus lötfähigem Metall hergestellt, um über einen Lötprozess in der richtigen Lage fixiert zu werden.

Zur Justage des Sende-/Empfangsmoduls 12 wird der Lichtsender 18 betrieben und das Empfangssignal in dem Lichtempfänger 22 beobachtet. Dabei bleibt der Lichtempfänger 22 in seiner Lage fixiert und nur der Lichtsender 18 wird zu seiner Sendeoptik 32 justiert. Eine energetisch bevorzugte Lage ist beispielsweise bei maximalem Empfangssignal gegeben, wobei applikationsabhängig auch andere Justagevorgaben denkbar sind.

Im Betrieb sendet der Lichtsender 18, beispielsweise im Puls- oder Dauerbetrieb, ein Lichtbündel 38 aus, welches durch den Abschirmtubus 34 begrenzt und von der Sendeoptik 32 strahlgeformt wird, so dass es annähernd als Lichtstrahl über den Drehspiegel 14 in einen Erfassungsbereich 40 des Sensors 10 trifft. Dort wird es an Objekten reflektiert oder remittiert und gelangt als Empfangslichtbündel 42 über die Empfangsoptik 24 zu dem Lichtempfänger 22.

Dabei befindet sich der Lichtsender 18 innerhalb des Strahlweges des Empfangslichtbündels 42 und damit im Empfangsbereich des Lichtempfängers 22. Deshalb ist der Lichtsender 18 auf einem schmalen Steg 44 in einer Aussparung 46 des ersten Leiterplattenabschnitts 16 montiert. Damit ist der Lichtsender 18 stabil gehaltert, zugleich bleibt aber der erste Leiterplattenabschnitt 16 für das Empfangslichtbündel 42 durchlässig.

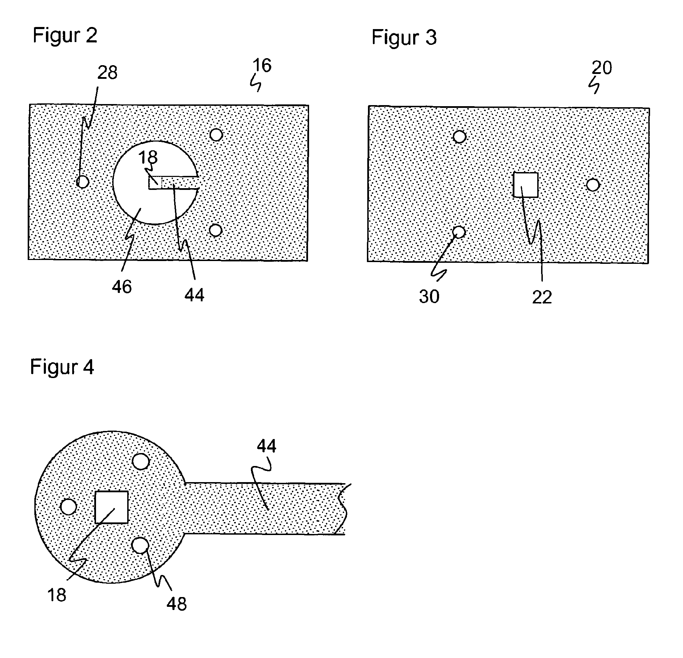

Figur 2 zeigt den ersten Leiterplattenabschnitt 16 und Figur 3 den zweiten Leiterplattenabschnitt 20 in einer Draufsicht. Dabei bezeichnen gleiche Bezugszeichen hier und im Folgenden die gleichen Merkmale. In Figur 2 sind die Dimensionen von Steg 44 und Aussparung 46 besser zu erkennen, als in der Schnittdarstellung der Figur 1.

Figur 4 zeigt den Steg 44 und einen Ausschnitt des Leiterplattenbereichs des Lichtsenders 18 als Detailansicht der Figur 2. Um den Lichtsender 18 herum sind Öffnungen 48 oder Pads vorgesehen, in denen der Abschirmtubus 34 montiert wird.

Bei der Herstellung werden der erste Leiterplattenabschnitt 16 mit Lichtsender 18 und der zweite Leiterplattenabschnitt 20 mit Lichtempfänger 22 sowie weiteren, nicht dargestellten Schaltungselementen bestückt und mit den Öffnungen 28, 30 und 48 sowie der Aussparung 46 versehen. Die Befestigungsbeine 26 der Empfangsoptik 24 mit der integrierten Sendeoptik 32 werden durch die Öffnungen 28 des ersten Leiterplattenabschnitts 16 gesteckt und in den Öffnungen 30 des zweiten Leiterplattenabschnitts 20 montiert. Der Lichtsender 18 wird gegenüber der Sendeoptik 32 justiert, um Fertigungstoleranzen auszugleichen, und anschließend die Lage der Tubus-Beinchen 36 in ihren Öffnungen 48 endgültig fixiert. Eine zusätzliche Fixierung der Befestigungsbeine 26 in den Öffnungen 28 und/oder 30 ist denkbar. Damit ist das Sende-/ Empfangsmodul 12 einsatzbereit.

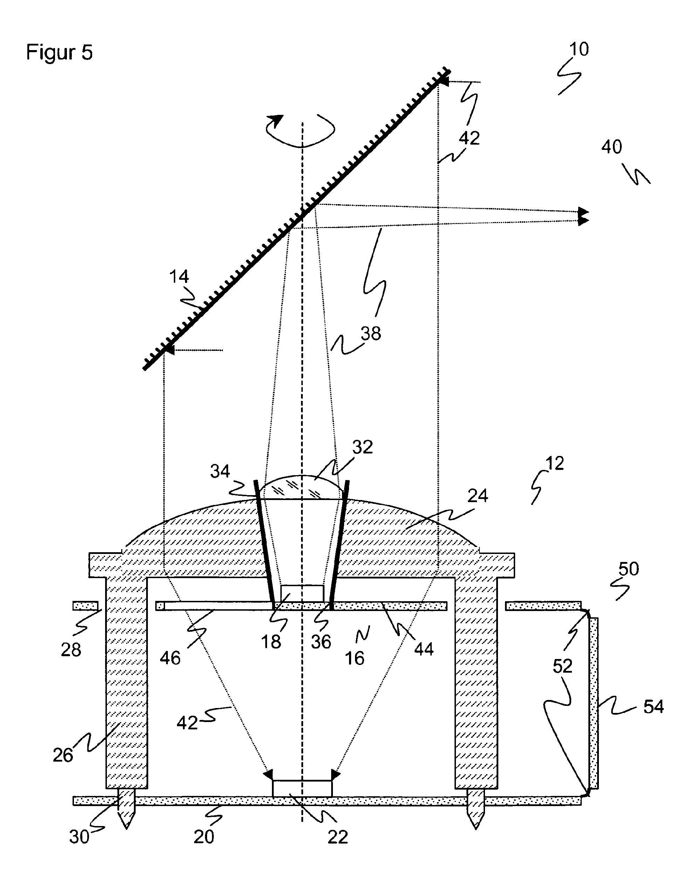

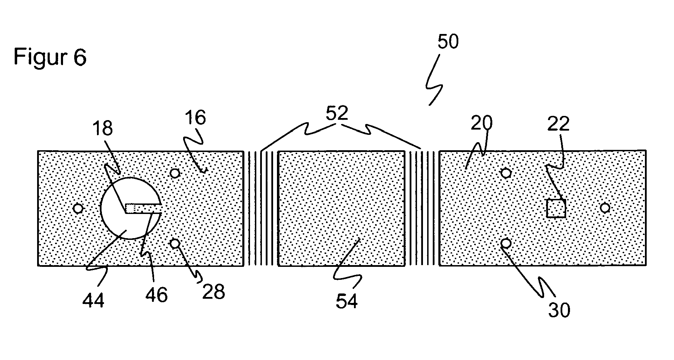

Eine weitere Ausführungsform der Erfindung ist in den Figuren 5 und 6 dargestellt. Dabei weist, wie die Schnittdarstellung der Figur 5 zeigt, im Unterschied zu der ersten Ausführungsform das Sende-/Empfangsmodul 12 eine einzige gemeinsame Leiterplatte 50 auf, die sowohl den ersten Leiterplattenabschnitt 16 als auch den zweiten Leiterplattenabschnitt 20 umfasst. Anstelle einer Kabelverbindung 23 sind flexible Verbindungsbereiche 52 der gemeinsamen Leiterplatte 50 vorgesehen.

Die gemeinsame Leiterplatte 50 umfasst einen zusätzlichen dritten Leiterplattenabschnitt 54. Die Leiterplatte ist an den flexiblen Verbindungsbereichen 18 zwischen dem ersten Leiterplattenabschnitt 16 und dem dritten Leiterplattenabschnitt 54 sowie zwischen dem dritten Leiterplattenabschnitt 54 und dem zweiten Leiterplattenabschnitt 20 um jeweils 90° gefaltet. Dadurch liegt der erste Leiterplattenabschnitt 16 in einer Ebene parallel zu dem zweiten Leiterplattenabschnitt 20 und damit der Lichtsender 18 in dem Empfangsbereich des Lichtempfängers 22. Dabei haben Lichtsender 18 und Lichtempfänger 22 bevorzugt dieselbe optische Achse. Anstelle eines dritten starren Leiterplattenabschnitts 54 sind prinzipiell auch ein oder mehrere im Vergleich zu Figur 5 ausgedehntere Verbindungsbereiche 52 denkbar.

Die in der Darstellung freibleibenden Bereiche der gemeinsamen Leiterplatte 50 einschließlich des dritten Leiterplattenabschnitts 54 können für weitere Schaltungselemente verwendet werden, beispielsweise Treiberschaltungen, Sensorsteuerung, Anschlüsse oder Auswertungseinheiten. Im optimalen Fall bleibt die gemeinsame Leiterplatte 50 die einzige Leiterplatte des Sensors 10. Alternativ sind zusätzliche Leiterplatten für weitere Schaltungselemente denkbar, die dann aber nicht mehr unmittelbar die Funktionalität und vor allem die Justage des Sende-/Empfangsmoduls 12 betreffen.

Figur 6 zeigt die gemeinsame Leiterplatte 50 aufgefaltet in einer Draufsicht. Der Lichtsender 18 ist dabei gestrichelt dargestellt, da er sich in der Darstellung auf der Rückseite der gemeinsamen Leiterplatte 50 befindet. Die Ausschnittvergrößerung des Leiterplattenbereichs um den Lichtsender ist mit der Figur 4 identisch.

Die Herstellung der zweiten Ausführungsform ist ganz ähnlich zu der ersten Ausführungsform. Statt zwei getrennte Leiterplattenabschnitte 16, 20 über die Befestigungsbeine 26 miteinander zu verbinden, wird hier lediglich die gemeinsame Leiterplatte 50 an den flexiblen Verbindungsbereichen 52 um jeweils 90° gefaltet.

## Patentansprüche

1. Optoelektronischer Sensor (10) mit einem Lichtsender (18) auf einem ersten Leiterplattenabschnitt (16) zum Aussenden eines Lichtstrahls (38) und einem Lichtempfänger (22) auf einem zweiten Leiterplattenabschnitt (20) zum Empfangen des remittierten oder reflektierten Lichtstrahls (42), wobei dem Lichtempfänger (22) eine Empfangsoptik (24) vorgeordnet ist, welche Abstandselemente (26) aufweist, mit denen die Empfangsoptik (24) in einer vorgegebenen Lage gegenüber dem Lichtempfänger (22) auf dem zweiten Leiterplattenabschnitt (20) montiert ist, und wobei die Leiterplattenabschnitte (16, 20) zueinander beabstandet angeordnet sind,
**dadurch gekennzeichnet,**
**dass** die Abstandselemente (26) Öffnungen (28) in dem ersten Leiterplattenabschnitt (16) durchdringen und somit die Lage des ersten Leiterplattenabschnitts (16) gegenüber der Lage des zweiten Leiterplattenabschnitts (20) fixieren.

2. Optoelektronischer Sensor (10) nach Anspruch 1,
wobei die Empfangsoptik (24) eine Empfangslinse aufweist, welche die Abstandselemente (26) aufweist, insbesondere in Form angespritzter Befestigungsbeine.

3. Optoelektronischer Sensor (10) nach einem der Ansprüche 1 oder 2,
wobei der Lichtsender (18) in einem Empfangsbereich des Lichtempfängers (22) angeordnet ist, insbesondere auf einem Steg (46) in einer Aussparung (44) des ersten Leiterplattenabschnitts (16).

4. Optoelektronischer Sensor (10) nach einem der vorhergehenden Ansprüche,
wobei eine Sendeoptik (32) in die Empfangsoptik (24) integriert ist, insbesondere die Sendeoptik (32) das Zentrum der Empfangsoptik (24) bildet.

5. Optoelektronischer Sensor (10) nach einem der vorhergehenden Ansprüche,
wobei ein Tubus (34) um die Sendeoptik (32) vorgesehen ist, um die Sendeoptik (32) von der Empfangsoptik (24) abzuschirmen, und wobei der Tubus (34) insbesondere Lötelemente zur Montage und Justierung in dem ersten Leiterplattenabschnitt (16) aufweist.

6. Optoelektronischer Sensor (10) nach einem der vorhergehenden Ansprüche,
wobei der erste Leiterplattenabschnitt (16) und der zweite Leiterplattenabschnitt (20) Teil einer gemeinsamen Leiterplatte (50) mit mindestens einem flexiblen Verbindungsbereich (52) sind, und wobei insbesondere ein dritter Leiterplattenabschnitt (54) zwischen dem ersten Leiterplattenabschnitt (16) und dem zweiten Leiterplattenabschnitt (20) vorgesehen ist und der Abstand zwischen Lichtsender (18) und Lichtempfänger (22) durch die Dimensionen des dritten Leiterplattenabschnitts (54) bestimmt ist.

7. Optoelektronischer Sensor (10) nach einem der vorhergehenden Ansprüche,
der als Scanner mit einem Drehspiegel (14) oder einem Polygonspiegelrad ausgebildet ist, mit dem der Lichtstrahl (38) periodisch über einen Scanbereich (40) ablenkbar ist, insbesondere ein Barcodeleser ist.

8. Optoelektronischer Sensor (10) nach einem der vorhergehenden Ansprüche,
der als entfernungsmessender Sensor nach einem Lichtlaufzeitprinzip ausgebildet ist, indem eine Auswertungseinheit des Sensors (10) die Lichtlaufzeit zwischen Aussenden und Empfang eines Lichtsignals oder den Phasenunterschied zwischen gesendetem und empfangenem moduliertem Licht (38, 42) bestimmt.

9. Verfahren zur Herstellung eines Sensors (10) nach einem der vorhergehenden Ansprüche, wobei ein Lichtsender (18) auf einem ersten Leiterplattenabschnitt (16) und ein Lichtempfänger (22) auf einem zweiten Leiterplattenabschnitt (20) montiert werden, die Leiterplattenabschnitte (16, 20) zueinander beabstandet angeordnet werden und dem Lichtempfänger (22) eine Empfangsoptik (24) vorgeordnet wird, welche mit Hilfe von Abstandselementen (26) in einer vorgegebenen Lage gegenüber dem Lichtempfänger (22) auf dem zweiten Leiterplattenabschnitt (20) montiert wird,
**dadurch gekennzeichnet,**
**dass** die Abstandselemente (26) durch Öffnungen (28) des ersten Leiterplattenabschnitts (16) hindurch gesteckt wird, um die Lage des ersten Leiterpiattenabschnitts (16) gegenüber der Lage des zweiten Leiterpiattenabschnitts (20) zu fixieren

10. Verfahren nach Anspruch 9,
wobei einer Empfangslinse der Empfangsoptik (24) als Abstandselemente (26) Befestigungsbeine angespritzt werden..

11. Verfahren nach Anspruch 9 oder 10,
wobei der Sensor (10) justiert wird, indem bei aktiviertem Lichtsender (18) durch Änderung der Lage des Lichtsenders (18) eine maximale oder eine vorgegebene Intensität des Empfangssignals des Lichtempfängers (22) eingestellt und anschließend die eingestellte Position fixiert wird, insbesondere durch Befestigen der Befestigungsbeine (26) in den Öffnungen (28).

12. Verfahren nach einem der Ansprüche 9 bis 11,
wobei ein Tubus (34) zwischen einer dem Lichtsender (18) zugeordneten Sendeoptik (32) und der Empfangsoptik (24) angeordnet und auf dem ersten Leiterplattenabschnitt (16) montiert wird.

13. Verfahren nach einem der Ansprüche 9 bis 12,
wobei um den Lichtsender (18) eine Aussparung (44) für das Empfangslicht angebracht wird, so dass der Lichtsender (16) nur noch von einen schmalen Steg (44) des ersten Leiterplattenabschnitts (16) gehalten wird.

14. Verfahren nach einem der Ansprüche 9 bis 13,
wobei der erste Leiterplattenabschnitt (16) und der zweite Leiterplattenabschnitt (20) Teil einer gemeinsamen Leiterplatte (50) mit mindestens einem flexiblen Verbindungsbereich (52) sind und wobei die gemeinsame Leiterplatte (50) mittels der Verbindungsbereiche (52) so gefaltet wird, dass der Lichtsender (18) in dem Empfangsbereich des Lichtempfängers (22) angeordnet ist.

## Claims

1. An optoelectronic sensor (10) having a light transmitter (18) on a first circuit board section (16) for transmitting a light beam (38) and a light receiver (22) on a second circuit board section (20) for receiving the remitted or reflected light beam (42), wherein reception optics (24) are arranged in front of the light receiver (22) which comprise spacer elements (26) by means of which the reception optics (24) are mounted on the second circuit board section (20) in a predetermined position relative to the light receiver (22), and wherein the circuit board sections (16, 20) are spaced from one another,
**characterized in that**
the spacer elements (26) penetrate openings (28) in the first circuit board section (16) and thus fix the position of the first circuit board section (16) relative to the position of the second circuit board section (20).

2. The optoelectronic sensor (10) according to claim 1,
wherein the reception optics (24) include a reception lens comprising the spacer elements (26), in particular in the form of integrally molded mounting legs.

3. The optoelectronic sensor (10) according to claim 1 or 2,
wherein the light transmitter (18) is arranged in a reception area of the light receiver (22), in particular on a protrusion (44) in a recess (46) of the first circuit board section (16).

4. The optoelectronic sensor (10) according to any of the preceding claims,
wherein transmission optics (32) are integrated into the reception optics (24), the transmission optics (32) in particular forming the center of the reception optics (24).

5. The optoelectronic sensor (10) according to any of the preceding claims,
wherein a tube (34) is provided around the transmission optics (24) to shield the transmission optics (32) from the reception optics (24), and wherein the tube (34) in particular comprises solder elements for assembly and adjustment in the first circuit board section (16).

6. The optoelectronic sensor (10) according to any of the preceding claims,
wherein the first circuit board section (16) and the second circuit board section (20) are part of a common circuit board (50) having at least one flexible connection portion (52), and wherein in particular a third circuit board section (54) is provided between the first circuit board section (16) and the second circuit board section (20) and the distance between light transmitter (18) and light receiver (22) is determined by the dimensions of the third circuit board section (54).

7. The optoelectronic sensor (10) according to any of the preceding claims, the sensor (10) being configured as a scanner having a rotary mirror (14) or a polygonal mirror by means of which the light beam (38) is periodically deflectable over a scanning area (40), the sensor (10) in particular being a bar code reader.

8. The optoelectronic sensor (10) according to any of the preceding claims, the sensor (10) being configured as a distance measuring sensor according to the light time of flight principle in that an evaluation unit of the sensor (10) determines the light time of flight between transmission and reception of a light signal or the phase difference between transmitted and received modulated light (38, 42).

9. A method for manufacturing a sensor (10) according to any of the preceding claims, wherein a light transmitter (18) is mounted on a first circuit board section (16) and a light receiver (22) is mounted on a second circuit board section (20), the circuit board sections (16, 20) are arranged spaced from one another and reception optics (24) are arranged in front of the light receiver (22) which are mounted in a predetermined position relative to the light receiver (22) on the second circuit board section (20) by means of spacer elements (26),
**characterized in that**
the spacer elements (26) are inserted through openings (28) in the first circuit board section (16) to fix the position of the first circuit board section (16) relative to the position of the second circuit board section (20).

10. The method according to claim 9,
wherein mounting legs are molded to reception lens of the reception optics (24) as the spacer elements (26).

11. The method according to claim 9 or 10,
wherein the sensor (10) is adjusted in that a maximum or predetermined intensity for the reception signal of the light receiver (22) is set by changing the position of the position of the light transmitter (18) with the light transmitter (18) activated, and the set position subsequently is fixed, in particular by fixing the mounding legs in the openings (28).

12. The method according to one of claims 9 to 11,
wherein a tube (34) is arranged between transmission optics (32) associated with the light transmitter (18) and the reception optics (24) and is mounted on the first circuit board section (16).

13. The method according to one of claims 9 to 12,
wherein a recess (46) for the reception light is formed around the light transmitter (18) so that the light transmitter (18) is only held by a narrow protrusion (44) of the first circuit board section (16).

14. The method according to one of claims 9 to 13,
wherein the first circuit board section (16) and the second circuit board section (20) are part of a common circuit board (50) having at least one flexible connection portion (52), and wherein the common circuit board (50) is folded by means of the connection portions (52) so that the light transmitter (18) is arranged in the reception area of the light receiver (22).

## Revendications

1. Capteur optoélectronique (10) comprenant un émetteur de lumière (18) sur une première portion de carte à circuits (16) pour émettre un rayon de lumière (38), et un récepteur de lumière (22) sur une seconde portion de carte à circuits (20) pour recevoir le rayon lumineux réémis ou réfléchi (42), dans lequel le récepteur de lumière (22) est précédé d'une optique de réception (24) qui comporte des éléments d'écartement (26) au moyen desquels l'optique de réception (24) est montée dans une position prédéterminée par rapport au récepteur de lumière (22) sur la seconde portion de carte à circuits (20), et dans lequel les portions de carte à circuits (16, 20) sont agencées à distance l'une de l'autre,
**caractérisé en ce que**
les éléments d'écartement (26) traversent des ouvertures (28) dans la première portion de cartes à circuit (16) et fixent ainsi la position de la première portion de carte à circuits (16) par rapport à la position de la seconde portion de carte à circuits (20).

2. Capteur optoélectronique (10) selon la revendication 1,
dans lequel l'optique de réception (24) comprend une lentille de réception qui comporte les éléments d'écartement (26), en particulier sous la forme de pieds de fixation rapportés par injection.

3. Capteur optoélectronique (10) selon l'une des revendications 1 ou 2,
dans lequel l'émetteur de lumière (18) est agencé dans une zone de réception du récepteur de lumière (22), en particulier sur une barrette (46) dans une échancrure (44) de la première portion de carte à circuits (16).

4. Capteur optoélectronique (10) selon l'une des revendications précédentes,
dans lequel une optique d'émission (32) est intégrée dans l'optique de réception (24), en particulier l'optique d'émission (32) forme le centre de l'optique de réception (24).

5. Capteur optoélectronique (10) selon l'une des revendications précédentes,
dans lequel il est prévu un organe tubulaire (34) autour de l'optique d'émission (32) afin de faire écran pour l'optique d'émission (32) vis-à-vis de l'optique de réception (24), et dans lequel l'organe tubulaire (34) comporte en particulier des éléments à braser pour le montage et l'ajustement dans la première portion de carte à circuits (16).

6. Capteur optoélectronique (10) selon l'une des revendications précédentes,
dans lequel la première portion de carte à circuits (16) et la seconde portion de carte à circuits (20) font partie d'une carte à circuits commune (50) avec au moins une zone de liaison flexible (52), et dans lequel il est en particulier prévu une troisième portion de carte à circuits (54) entre la première portion de carte à circuits (16) et la seconde portion de carte à circuits (20), et la distance entre l'émetteur de lumière (18) et le récepteur de lumière (22) est déterminée par les dimensions de la troisième portion de carte à circuits (54).

7. Capteur optoélectronique (10) selon l'une des revendications précédentes, qui est réalisé comme scanner avec un miroir rotatif (14) ou une roue à miroir polygonal avec lequel/laquelle le rayon de lumière (38) peut être défléchi périodiquement sur une zone de scannage (40), et est en particulier un lecteur de codes à barres.

8. Capteur optoélectronique (10) selon l'une des revendications précédentes, qui est réalisé comme capteur de mesure de distance selon le principe de temps de parcours de la lumière, dans lequel une unité d'évaluation du capteur (10) détermine le temps de parcours de la lumière entre l'émission et la réception d'un signal lumineux, ou la différence de phase entre une lumière modulée émise et reçue (38, 42).

9. Procédé pour la réalisation d'un capteur (10) selon l'une des revendications précédentes, dans lequel un émetteur de lumière (18) est monté sur une première portion de carte à circuits (16) et un récepteur de lumière (22) est monté sur une seconde portion de carte à circuits (20), les portions de carte à circuits (16, 20) sont agencées à distance l'une de l'autre, et le récepteur de lumière (22) est précédé par une optique de réception (24) qui est montée sur la seconde portion de carte à circuits (20) dans une position prédéterminée par rapport au récepteur de lumière (22) à l'aide d'éléments d'écartement (26),
**caractérisé en ce que**
les éléments d'écartement (26) sont enfilés à travers des ouvertures (28) de la première portion de carte à circuits (16) afin de fixer la position de la première portion de carte à circuits (16) par rapport à la position de la seconde portion de carte à circuits (20).

10. Procédé selon la revendication 9,
dans lequel des pieds de fixation sont rapportés sur une lentille de réception de l'optique de réception (24) à titre d'éléments d'écartement (26).

11. Procédé selon la revendication 9 ou 10,
dans lequel le capteur (10) est ajusté du fait que, lorsque l'émetteur de lumière (18) est activé, on règle par modification de la position de l'émetteur de lumière (18), une intensité maximum ou une intensité prédéterminée du signal de réception du récepteur de lumière (22) et la position réglée est ensuite fixée, en particulier par fixation des pieds de fixation (26) dans les ouvertures (28).

12. Procédé selon l'une des revendications 9 à 11,
dans lequel un organe tubulaire (34) est agencé entre une optique d'émission (32) associée à l'émetteur de lumière (18) et l'optique de réception (24), et est monté sur la première portion de carte à circuits (16).

13. Procédé selon l'une des revendications 9 à 12,
dans lequel une échancrure (44) est ménagée autour de l'émetteur de lumière (18) pour la lumière reçue, de sorte que l'émetteur de lumière (18) n'est plus tenu que par une étroite barrette (44) de la première portion de carte à circuits (16).

14. Procédé selon l'une des revendications 9 à 13,
dans lequel la première portion de carte à circuits (16) et la seconde portion de carte à circuits (20) font partie d'une carte à circuits commune (50) avec au moins une zone de liaison flexible (52), et dans lequel la plaque à circuits commune (50) est repliée au moyen des zones de liaison (52) de telle façon que l'émetteur de lumière (18) est agencé dans la zone de réception du récepteur de lumière (22).
